# EUROPÄISCHE PATENTSCHRIFT

(11) **EP 0 420 050 B1**
(45) Veröffentlichungstag und Bekanntmachung des Hinweises auf die Patenterteilung: **28.12.1994**
(21) Anmeldenummer: 90118136.2
(22) Anmeldetag: 20.09.1990
(51) Int. Cl.: H05K 3/34

(54) **Verfahren zum Auflöten von Bauelementen auf Leiterplatten**
Method of soldering of components on circuit boards
Procédé de soudage de composants sur une plaque de circuit

(30) Priorität: 29.09.1989 DE 3932702
(43) Veröffentlichungstag der Anmeldung: 03.04.1991
(73) Patentinhaber: Siemens Nixdorf Informationssysteme Aktiengesellschaft, 33102 Paderborn (DE)
(72) Erfinder: Schuster, Rudolf, Dipl.-Ing., D-8011 Heimstetten (DE); Raschke, Josef, D-8011 Gelting (DE); Bloessl, Hermann, D-8000 München 70 (DE)
(74) Vertreter: Fuchs, Franz-Josef, Dr.-Ing.

(56) Entgegenhaltungen:
- DE-A- 2 640 613
- ELEKTRONIK, Bd. 35, Nr. 25, 12. Dezember 1986, MUNCHEN, DE, Seiten 57 - 64; G. ZSCHIMMER: 'IMPULSLöTEN - DIE ALTERNATIVE Für SMD's
- PATENT ABSTRACTS OF JAPAN, vol. 13, no. 493 (E-842)(3841) 8. November 1989 & JP-A-01 196 896
- PATENT ABSTRACTS OF JAPAN, vol. 6, no. 230 (E-142)16. November 1982 & JP-A-57 133 643
- PATENT ABSTRACTS OF JAPAN, vol. 10, no. 73 (M-463)(2130) 22. März 1986 & JP-A-60 216 974

## Beschreibung

Die Erfindung betrifft ein Verfahren zum Auflöten von Bauelementen auf Leiterplatten unter Verwendung einer Lötvorrichtung mit mindestens einer durch elektrische Widerstandswärme erhitzbaren Bügelelektrode.

Lötvorrichtung mit an einem Lötbügelhalter befestigten und durch elektrische Widerstandswärme erhitzbaren Bügelelektroden sind beispielsweise aus der DE-A-31 49 236, der DE-A-28 18 958 oder der EP-A-0 011 046 bekannt. Dabei werden solche Lötvorrichtungen mit zwei parallel einander gegenüberliegenden oder mit vier paarweise einander gegenüberliegenden Bügelelektroden insbesondere für das Auflöten hochpoliger elektronischer Bauelemente wie Mikropacks, Flatpacks und dergleichen eingesetzt. Wird eine derartige Lötvorrichtung zusätzlich mit einer mittig zwischen den Bügelelektroden angeordneten Saugpipette ausgerüstet, so kann diese für die automatische Bestückung der Leiterplatten mit den aufzulötenden Bauelementen herangezogen werden. Bei der Bestückung nach dem sogenannten Pick & Place Prinzip bewegt sich der kombinierte Bestück- und Lötkopf über den Zuführmodulen der Bauelmente und der im Bestückbereich angeordneten Leiterplatte, wobei die Saugpipette das jeweilige Bauelement aus einem Zuführmodul aufnimmt und in der vorgegebenen Bestückposition auf der Leiterplatte absetzt. Nach dem Absetzen des jeweiligen Bauelements wird dann der Lötbügelhalter abgesenkt, so daß sich sowohl vor dem Lötvorgang als auch während der gesamten Dauer des Lötvorganges ein möglichst sicherer Kontakt zwischen den Arbeitsflächen der Bügelelektroden, den Anschlußbeinchen des Bauelements und den Leiterbahnen bzw. Anschlußpads der Leiterplatte ergibt. Die Saugpipette kann bis zur Beendigung des Lötvorganges auf dem Bauelement verbleiben und dieses mit einer begrenzten Kraft gegen die Lötstelle auf der Leiterplatte drücken.

Bei dem durch die elektrische Widerstandserwärmung der Bügelelektroden ausgelösten Lötvorgang schmilzt das für die Lötung vorgesehene Lot auf, was zu einem sogenannten Einsacken oder Nachsacken der Bügelelektroden führt. Die Größe des entsprechenden Einsackhubes der Bügelelektroden ist dabei in erster Linie von der auf den Lötbügelhalter ausgeübten Kraft abhängig, wobei jedoch auch andere Faktoren wie z.B. verbogene oder unterschiedlich ausgeformte Anschlußbeinchen der Bauelemente oder wie eine Schieflage der Bauelemente auf der Leiterplatte einen nicht unerheblichen Einfluß ausüben können. Diese von Bauelement zu Bauelement unterschiedlichen Bedingungen für das Einsacken oder Nachsacken der Bügelelektroden führt dann zwangsläufig zu unterschiedlich ausgebildeten Lötstellen, bei welchen häufig die erwünschte Sicherheit und Qualität der Lötung nicht erreicht wird.

Ein weiteres Verfahren zum Auflöten von Bauelementen ist aus JP-A-57 133 643 bekannt.

Der Erfindung liegt die Aufgabe zugrunde ein Verfahren zum Auflöten von Bauelementen auf Leiterplatten zu schaffen, bei welchem die Anschlußbeinchen der Bauelemente mit den zugeordneten Leiterbahnen oder Anschlußpads der Leiterplatten durch zumindest weitgehend reproduzierbare Lötungen gleichbleibend hoher Qualität miteinander verbunden werden.

Die Lösung dieser Aufgabe erfolgt erfindungsgemäß durch folgende Schritte:
a) Aufsetzen des Bauelements auf die vorgegebene Bestückposition der Leiterplatte,
b) Absenken mindestens einer Bügelelektrode auf die Anschlußbeinchen des Bauelements;
c) Ausübung einer Kraft auf die Bügelelektrode zum Andrücken der Anschlußbeinchen an die zugeordneten Leiterbahnen oder Anschlußpads der Leiterplatte;
d) Erwärmung der Bügelelektrode zum Aufschmelzen des für die Lötung vorgesehenen Lotes;
e) weitere Zustellung der Bügelelektrode zum Nachdrücken der Anschlußbeinchen in das aufgeschmolzene Lot;
f) Bildung einer Lotschicht zwischen Anschlußbeinchen und Leiterbahnen der Anschlußpads durch Verringerung der auf die Bügelelektrode ausgeübten Kraft und/oder definiertes Zurücksetzen der Bügelelektrode.

Der Erfindung liegt die Erkenntnis zugrunde, daß beim Nachdrücken der Anschlußbeinchen in das aufgeschmolzene Lot beispielsweise durch ein vorzeitiges Aufsitzen eines oder mehrerer Anschlußbeinchen unterschiedlich ausgestaltete Lötstellen entstehen und daß diese Unterschiede durch Verringerung der auf die Bügelelektrode ausgeübten Kraft und/oder definiertes Zurücksetzen der Bügelelektrode kompensiert werden kann. Diese beiden einzeln oder zusammen vorgenommenen Maßnahmen bewirken dann die Bildung definierter Lotschichten zwischen den Anschlußbeinchen und den zugeordneten Leiterbahnen oder Anschlußpads.

Gemäß einer bevorzugten Ausgestaltung des erfindungsgemäßen Verfahrens wird im Schritt a) das Bauelement mit einer Saugpipette aufgesetzt und das Bauelement durch Ausübung einer begrenzten Kraft auf die Saugpipette gegen die Leitplatte gedrückt. In diesem Fall kann dann nach einem definierten Zurücksetzen der Bügelelektrode das Bauelement mit der Saugpipette gegen die Bügelelektrode zurückgezogen werden, so daß bei sämtlichen Lötstellen eines Lötvorganges Lotschichten gleicher Stärke gewährleistet sind.

Gemäß einer weiteren besonders bevorzugten Ausgestaltung des erfindungsgemäßen Verfahrens wird die weitere Zustellung gemäß Schritt e) überwacht und auf einen vorgegebenen Wert begrenzt. Durch eine derartige Überwachung und Begrenzung des Einsackhubes kan die Qualität der einzelnen Lötstellen noch weiter verbessert werden und außerdem ein unerwünschtes seitliches Austreten des schmelzflüssigen Lotes zwischen Anschlußbeinchen und Leiterbahnen oder Anschlußpads verhindert werden.

Ein Ausführungsbeispiel der Erfindung ist in der Zeichnung dargestellt und wird im folgenden näher beschrieben.

Es zeigen
- Fig. 1: eine Lötvorrichtung mit einem auf einer Leiterplatte positionierten und nachfolgend zu verlötenden Bauelement,
- Fig. 2: die Lötvorrichtung gemäß Figur 1 nach dem Auflöten des Bauelements und
- Fig. 3: die Abhängigkeit wesentlicher Verfahrensparameter eines Lötvorganges von der Zeit bei der in den Figuren 1 und 2 aufgezeigten Lötung.

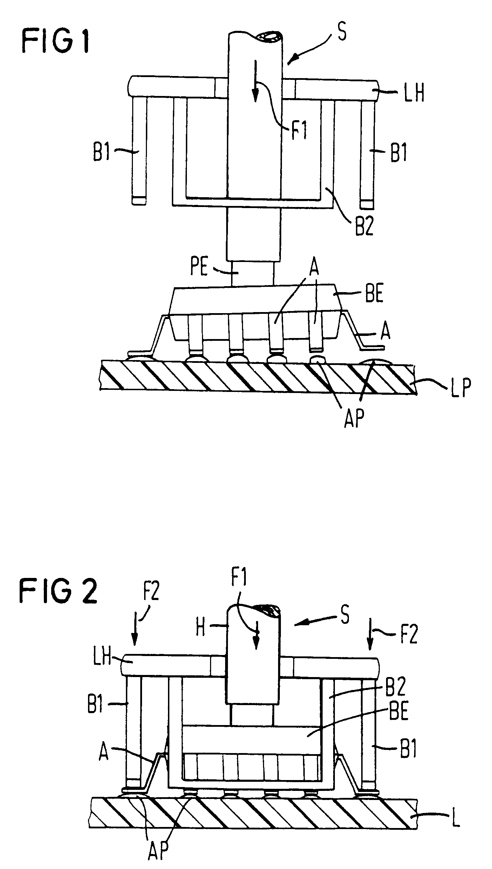

Fig. 1 zeigt in stark vereinfachter schematischer Darstellung das Grundprinzip einer bei dem erfindungsgemäßen Verfahren eingesetzten Lötvorrichtung, wobei die zum Verständnis der Erfindung nicht erforderlichen Teile wie Stromzuführungen und dergleichen weggelassen wurden. Die dargestellte Lötvorrichtung besitzt vier an einem Lötbügelhalter LH befestigte U-förmige Bügelelektroden, wobei jeweils zwei Bügelelektroden B1 und zwei Bügelelektroden B2 derart im Abstand zueinander parallel ausgerichtet sind, daß die Arbeitsflächen auf der Unterseite der Bügelelektroden B1 und B2 einen in den Endbereichen nicht geschlossenen rechteckförmigen oder quadratischen Rahmen bilden. Die Abmessungen dieses Rahmens sind dabei auf die Form und Lage der Anschlußbeinchen A eines auf die Anschlußpads AP einer Leiterplatte LP aufzulötenden Bauelements BE abgestimmt.

Die aufzulötenden Bauelemente BE werden mit der Saugpipette S eines in der Zeichnung nicht näher dargestellten Bestückkopfes aus einem Magazin oder aus einem Zuführmodul entnommen und auf die vorgegebene Lötstelle auf der Leiterplatte LP abgesetzt. Aufbau und Wirkungsweise eines mit einer Saugpipette ausgerüsteten Bestückkopfes gehen beispielsweise aus der US-A-4 135 630 hervor.

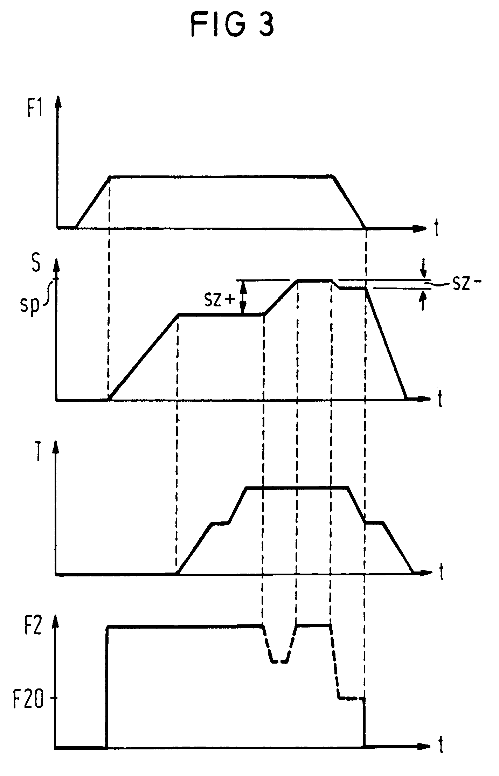

Beim Aufsetzen des Bauelements BE auf die vorgegebene Bestückposition der Leiterplatte LP sollen die zweifach abgegebogenen Anschlußbeinchen A mit dem Anschlußpads AP in Kontakt kommen. Aufgrund eines Winkelversatzes der Leiterplatte LP, durch Verwölbung der Leiterplatte LP, durch unterschiedliche Höhen der Anschlußpads AP, durch unterschiedlich gebogene Anschlußbeinchen A oder durch ähnliche Ursachen kann es jedoch zu einer in Figur 1 übertrieben dargestellten Schieflage des Bauelementes BE relativ zur Leiterplatte LP kommen. Im Hinblick auf eine derartige Schieflage des Bauelements BE trägt die Saugpipette S an ihrem unteren Ende einen Pipetten-Einsatz PE, der aus einem elastisch verformbaren Material besteht und sich damit an die Lage des Bauelements BE anpassen kann. Durch diese elastische Anpassung des beispielsweise aus Hartgummi oder Silikonkautschuk bestehenden Pipetten-Einsatzes PE kann dann die Saugpipette S problemlos dazu benutzt werden, das genau positionierte Bauelement BE vor dem Lötvorgang bis zu einer Zeit kurz vor Beendigung des Lötvorganges mit einer auch in Figur 3 dargestellten begrenzten Kraft F1 von beispielsweise 0,1 N bis 0,5 N gegen die Leiterplatte LP zu drücken.

Gemäß Figur 2 wird nach dem Positionieren und Andrücken des Bauelements BE der Lötbügelkontakt LH nach unten gefahren, d. h. die Bügelelektroden B1 und B2 werden auf die Anschlußbeinchen A des Bauelements BE abgesenkt. Durch Ausübung einer auch in Figur 3 dargestellten Kraft F2 von beispielsweise 40 N werden dann die Anschlußbeinchen A über die Bügelelektroden B1 bzw. B2 an die zugeordneten Anschlußpads AP der Leiterplatte LP gedrückt.

Sobald die volle Andrückkraft F2 erreicht ist, beginnt dann die elektrische Widerstandserwärmung der Bügelelektroden B1 und B2 zum Aufschmelzen des für die Lötung vorgesehenen Lots der Anschlußpads AP. Der zeitliche Verlauf der Temperatur T der Bügelelektroden B1 und B2 über die gesamte Dauer des Lötvorganges ist ebenfalls in Fig. 3 dargestellt.

Aus Figur 3 ist auch der Weg bzw. die Zustellung S in Abhängigkeit von der Zeit t für die gesamte Dauer eines Lötvorganges ersichtlich. Dabei ist zu erkennen, daß nach dem Absenken der Bügelelektroden B1 und B2 und dem kurz nach Erreichen der maximalen Temperatur beginnenden Aufschmelzen des Lotes die Anschlußbeinchen A in das aufgeschmolzene Lot nachgedrückt werden. Dieses Nachdrücken ist durch die weitere Zustellung sz+ der Bügelelektroden B1 und B2 aufgezeigt. Die weitere Zustellung sz+ - die auch als Einsackhub bezeichnet werden kann - wird durch ein in der Zeichnung nicht dargestelltes Wegmaßsystem überwacht und auf einem vorgegebenen, programmierbaren Wert SP begrenzt. Die weitere Zustellung beträgt beispielsweise 20 bis 30 Mikrometer.

Nach Erreichen des durch die weitere Zustellung sz+ gekennzeichneten Einsackhubes wird die auf die Bügelelektroden B1 und B2 ausgeübte Kraft F2 auf eine programmierte Kraft F20 von beispielsweise 10 bis 15 N reduziert. Anschließend erfolgt ein definiertes Zurücksetzen sz- der Bügelelektroden B1 und B2 um einen Betrag von beispielsweise 10 Mikrometer. Nach dem definierten Zurücksetzen sz- wird dann auch das Bauelement BE mit der Saugpipette S gegen die Bügelelektroden B1 und B2 zurückgezogen. Diese zuletzt genannte Maßnahme kann jedoch dann entfallen, wenn die Anschlußbeinchen A aufgrund ihrer Elastizität gegen die zurückgesetzten Bügelelektroden B1 und B2 drücken.

Die vorstehend geschilderte Verringerung der auf die Bügelelektroden B1 und B2 ausgeübten Kraft F2 und das definierte Zurücksetzen sz- der Bügelelektroden B1 und B2 bewirken die Bildung einer definierten Lotschicht zwischen den Anschlußbeinchen A und der Leiterplatte LP. Diese definierte Lotschicht ist in Figur 2 durch die Form der aufgeschmolzenen und nach Beendigung des Lötvorganges wieder erstarrten Anschlußpads AP aufgezeigt. Die Bildung einer definierten Lotschicht kann in vielen Fällen auch allein durch eine entsprechende Verringerung der Kraft F2 oder auch allein durch ein definiertes Zurücksetzen sz- der Bügelelektroden B1 und B2 bewirkt werden.

## Patentansprüche

1. Verfahren zum Auflöten von Bauelemten (BE) auf Leiterplatten (LP), mit folgenden Schritten:
a) Aufsetzen des Bauelements (BE) auf die vorgegebene Bestückposition der Leiterplatte (LP);
b) Absenken mindestens einer Bügelelektrode (B1,B2) auf die Anschlußbeinchen (A) des Bauelements (BE);
c) Ausübung einer Kraft (F2) auf die Bügelelektrode (B1,B2) zum Andrücken der Anschlußbeinchen (A) an die zugeordneten Leiterbahnen oder Anschlußpads (AP) der Leiterplatte (LP);
d) Erwärmung der Bügelelektrode (B1,B2) zum Aufschmelzen des für die Lötung vorgesehenen Lotes;
e) weitere Zustellung (sz+) der Bügelelektrode (B1,B2) zum Nachdrücken der Anschlußbeinchen (A) in das aufgeschmolzene Lot;
f) Bildung einer Lotschicht zwischen Anschlußbeinchen (A) und Leiterbahnen oder Anschlußpads (AP) durch Verringerung der auf die Bügelelektrode (B1,B2) ausgeübten Kraft (F2) und/oder definiertes Zurücksetzen (sz-) der Bügelelektrode (B1,B2).

2. Verfahren nach Anspruch 1,
**dadurch gekennzeichnet,**
daß im Schritt a) das Bauelement (BE) mit einer Saugpipette (S) aufgesetzt wird und daß das Bauelement (BE) durch Ausübung einer begrenzten Kraft (F1) auf die Saugpipette (S) gegen die Leiterplatte (LP) gedrückt wird.

3. Verfahren nach Anspruch 2,
**dadurch gekennzeichnet,**
daß nach einem definierten Zurücksetzen (sz-) der Bügelelektrode (B1,B2) das Bauelement (BE) mit der Saugpipette (S) gegen die Bügelelektrode (B1,B2) zurückgezogen wird.

4. Verfahren nach einem der vorhergehenden Ansprüche,
**dadurch gekennzeichnet,**
daß die weitere Zustellung (sz+) gemäß Schritt e) überwacht und auf einen vorgegebenen Wert (sp) begrenzt wird.

## Claims

1. Method for soldering components (BE) on printed circuit boards (LP), having the following steps:
a) placing the component (BE) on the specified fitting position of the printed circuit board (LP);
b) lowering at least one soldering-iron electrode (B1, B2) on the connecting legs (A) of the component (BE);
c) exerting a force (F2) on the soldering-iron electrode (B1, B2) for pressing the connecting legs (A) on the associated conductor tracks or connecting pads (AP) of the printed circuit board (LP);
d) heating the soldering-iron electrode (B1, B2) for melting the solder provided for the soldering;
e) further advancing (sz+) the soldering-iron electrode (B1, B2) for subsequently pressing the connecting legs (A) into the molten solder;
f) formation of a solder layer between the connecting legs (A) and conductor tracks or connecting pads (AP) by reducing the force (F2) exerted on the soldering-iron electrode (B1, B2) and/or defined retraction (sz-) of the soldering-iron electrode (B1, B2).

2. Method according to Claim 1, characterized in that step a) involves placing the component (BE) by means of a suction pipette (S) and in that the component (BE) is pressed against the printed circuit board (LP) by exerting a limited force (F1) on the suction pipette (S).

3. Method according to Claim 2, characterized in that after a defined retraction (sz-) of the soldering-iron electrode (B1, B2), the component (BE) is withdrawn towards the soldering-iron electrode (B1, B2) by means of the suction pipette (S).

4. Method according to one of the preceding claims, characterized in that the further advancing (sz+) in accordance with step e) is monitored and is limited to a specified value (sp).

## Revendications

1. Procédé pour fixer par brasage des composants (BE) sur des plaquettes à circuits imprimés (LP), comportant les étapes suivantes :
a) mise en place du composant (BE) dans la position d'équipement prédéterminée de la plaquette à circuits imprimés (LP);
b) abaissement au moins d'une électrode en forme d'étrier (B1,B2) sur les petites pattes de raccordement (A) du composant (BE);
c) application d'une force (F2) à l'électrode en forme d'étrier (B1,B2) pour appliquer les petites pattes de raccordement (A) sur les voies conductrices associées ou les plots de connexion (AP) de la plaquette à circuits imprimés (LP);
d) chauffage de l'électrode en forme d'étrier (B1,B2) pour faire fondre la brasure prévue pour le brasage;
e) avance supplémentaire (sz+) de l'électrode en forme d'étrier (B1,B2) pour repousser les petites pattes de raccordement (A) dans la brasure fondue;
f) formation d'une couche de brasure entre des petites pattes de raccordement (A) et des voies conductrices ou des plots de connexion (AP) en réduisant la force (F2) appliquée à l'électrode en forme d'étrier (B1,B2) et/ou par un retrait défini (sz-) de l'électrode en forme d'étrier (B1,B2).

2. Procédé suivant la revendication 1, caractérisé par le fait que lors de l'étape (a), on met en place le composant (BE) au moyen d'une pipette à aspiration (S) et qu'on applique le composant (BE) sur la plaquette à circuits imprimés (LP) par application d'une force limitée (F1) à la pipette à aspiration (S).

3. Procédé suivant la revendication 2, caractérisé par le fait qu'après un retiré défini (sz-) de l'électrode en forme d'étrier (B1,B2), on rétracte le composant (B1) avec la pipette à aspiration (S) sur l'électrode en forme d'étrier (B1,B2).

4. Procédé suivant l'une des revendications précédentes, caractérisé par le fait que l'avance supplémentaire (sz+) exécutée lors de l'étape (e) est contrôlée et limitée à une valeur prédéterminée (sp).
